# FASCICULE DE BREVET EUROPEEN

(11) **EP 3 201 121 B1**
(45) Date de publication et mention de la délivrance du brevet: **23.04.2025**
(21) Numéro de dépôt: 15771957.6
(22) Date de dépôt: 30.09.2015
(51) Int. Cl.: B81B 3/00, H10N 30/20

(54) **STRUCTURE MECANIQUE COMPRENANT UN ACTIONNEUR ET DES MOYENS D'AMPLIFICATION MECANIQUE ET PROCEDE DE FABRICATION**
MECHANISCHE STRUKTUR MIT EINEM STELLGLIED UND MECHANISCHES VERSTÄRKUNGSMITTEL SOWIE HERSTELLUNGSVERFAHREN
MECHANICAL STRUCTURE COMPRISING AN ACTUATOR AND MECHANICAL AMPLIFICATION MEANS, AND PRODUCTION METHOD

(30) Priorité: 02.10.2014 FR 1459430
(43) Date de publication de la demande: 09.08.2017
(73) Titulaire: Commissariat à l'Energie Atomique et aux Energies Alternatives, 75015 Paris (FR); Université Grenoble Alpes, 38400 Saint-Martin-d'Hères (FR)
(72) Inventeur: CASSET, Fabrice, F-38570 Tencin (FR); BASROUR, Skandar, F-38100 Grenoble (FR); CHAPPAZ, Cédrick, F-38920 Crolles (FR); DANEL, Jean-Sébastien, F-38130 Echirolles (FR)
(74) Mandataire: Atout PI Laplace
(86) Numéro de dépôt international: PCT/EP2015/072536
(87) Numéro de publication internationale: WO 2016/050832

(56) Documents cités:
- WO-A1-2014/091089
- US-A1- 2010 090 565
- US-A1- 2013 342 075

## Description

L'invention concerne de manière générale des structures mécaniques dans lesquelles on cherche à transmettre une déformation ou un mode de vibration à un élément mécanique à l'aide d'un actionneur et notamment un actionneur réalisé par des techniques de la microélectronique.

Une telle problématique est présente dans de très nombreux domaines d'application tels que ceux cités ci-après de façon non-exhaustive.

Aujourd'hui différents systèmes utilisent des actionneurs par exemple de type piézoélectriques céramiques (dalles haptiques, « jet d'encre »...). Ces céramiques doivent être placées individuellement sur le système final et requièrent de fortes tensions d'actionnement (typiquement 100 à 200V).

En parallèle, l'utilisation d'actionneurs déposés en couches minces par les procédés de la microélectronique permet de réaliser collectivement de nombreux systèmes par partage d'étape (une étape de microélectronique est réalisée en même temps sur tous les systèmes présents sur le substrat), et ainsi permet de réduire les coûts de fabrication. De plus, les actionneurs couches minces permettent d'actionner les systèmes électromécaniques en utilisant de faibles tensions (typiquement 10-20V). Néanmoins, du fait de leur faible épaisseur et petites dimensions, ces actionneurs présentent une déformation moindre que celle obtenue avec les céramiques piézoélectriques, et transmettent moins de force ou engendre moins de déplacement que les céramiques.

Un exemple d'application concerne l'interface haptique. Actuellement, les constructeurs de téléphones portables qui se sont lancés dans les mobiles à écran tactile, cherchent à se démarquer en intégrant une interface haptique à retour de force sur leurs appareils. Ainsi, lorsqu'un utilisateur vient glisser son doigt sur une icône située sur l'écran, il peut ressentir une légère vibration provenant du mobile, vibration sensée lui retranscrire l'impression de pression sur un bouton. Néanmoins, à ce jour, les systèmes haptiques embarqués par exemple dans des téléphones portables, présentent un effet haptique limité (simple vibration) et une surconsommation électrique.

Un autre exemple d'application pour lequel il est intéressant d'amplifier la déformation d'un actionneur se situe dans les domaines dans lesquels on cherche à réaliser un switch ou une capacité variable.

Cette problématique se retrouve également lorsque l'on cherche à réaliser par exemple un haut-parleur MEMS, utilisant un actionneur sur une membrane. L'actionnement de la membrane permet de réaliser un pulse acoustique.

Cette même problématique est aussi présente dans le domaine de l'imagerie photoacoustique. Dans ce cas le pulse acoustique, crée par le déplacement de l'air engendré par l'actionnement de la membrane, est envoyé sur une cellule ou un élément à « sonder ». La réflexion de l'onde acoustique peut être enregistrée et analysée pour faire de l'imagerie.

On peut encore mentionner des domaines d'application tels que ceux des micro-pompes, utilisant le déplacement d'une membrane pour servir de micro-pompe, et ce par exemple pour dispenser de l'insuline ou tout autre médicament.

La publication de demande de brevet US2010/090565 A1 décrit une structure mécanique comportant : un membre élastique; un actionneur piézoélectrique dont la hauteur peut varier, situé à la surface d'un substrat ; une barre de transfert mécanique entre ledit actionneur et ledit membre élastique ; la barre de transfert pouvant comporter une encoche.

Dans ce contexte général, il demeure intéressant et nécessaire de pouvoir disposer de petites structures dans lesquelles un effet introduit au niveau d'un actionneur peut être transmis de manière amplifiée à un élément auquel est couplé cet actionneur.

C'est pourquoi, la présente invention a pour objet une structure mécanique telle que définie par la revendication 1.

Selon une variante de l'invention, le substrat actif étant orienté selon un premier plan défini par deux axes orthogonaux X et Y, défini dans un repère orthormé (X, Y, Z), la tranchée est orientée selon un plan comprenant un axe Z' faisant un angle θ avec ledit axe Z, cet angle pouvant être nul.

Selon une variante de l'invention, ladite structure élémentaire comprend un empilement de couches dont au moins une couche comprend ladite tranchée.

Selon une variante de l'invention, le substrat présentant une surface orientée dans un premier plan défini par deux axes X et Y orthogonaux, ladite structure élémentaire comprend des tranchées réparties périodiquement selon ledit premier plan entre ledit actionneur et ledit substrat.

Selon une variante de l'invention, ladite structure comprend plusieurs actionneurs couplés à au moins une structure élémentaire d'amplification, sur ledit substrat actif.

Selon une variante de l'invention, l'actionneur est un actionneur piézoélectrique.

Selon une variante de l'invention, l'actionneur piézoélectrique comprend au moins une couche de matériau piézoélectrique pouvant être en PZT, ou AIN, ou en LNO, ou en BST.

Selon une variante de l'invention, l'actionneur comprend une résistance thermique pouvant comprendre au moins une couche de métal, adaptée pour assurer un actionnement thermique.

Selon une variante de l'invention, l'actionneur comprend au moins une couche en matériau magnétique, permettant d'assurer un actionnement magnétique.

Selon une variante de l'invention, le substrat actif est tout ou partie en verre, ou en polymère, ou en silicium.

Ce substrat peut-être homogène (encore appelé substrat « bulk ») ou hétérogène, c'est dire comportant un empilement de couches.

Selon une variante de l'invention, la structure élémentaire comprend au moins une partie en silicium.

Selon une variante de l'invention, ladite structure comprend :
- un actionneur pouvant comprendre une couche piézoélectrique ;
- une structure élémentaire en silicium ;
- un substrat actif en verre.

Selon une variante de l'invention, la ou les tranchées présentent une largeur comprise entre environ de 5 µm et 1000 µm et dans le cas de plusieurs tranchées, elles sont espacées d'une distance pouvant typiquement être comprise entre 5 µm à 1000 µm.

L'invention a aussi pour objet un procédé de fabrication d'une structure mécanique comprenant un empilement comportant un substrat actif et au moins un actionneur adapté pour générer des vibrations au niveau dudit substrat actif, ledit empilement comprenant une structure élémentaire d'amplification desdites vibrations :
- disposée entre ledit actionneur et ledit substrat actif, la structure étant adaptée pour transmettre et amplifier lesdites vibrations et ;
- comprenant au moins une tranchée, située entre ledit actionneur et ledit substrat actif,
   caractérisé en ce qu'il comprend les étapes suivantes :
   - la réalisation d'au moins un actionneur à la surface d'un substrat élémentaire ;
   - une opération de collage dudit substrat élémentaire côté actionneur, sur un substrat temporaire ;
   - la réalisation d'au moins une tranchée dans ledit substrat élémentaire, en face opposée à celle comportant ledit actionneur, le substrat élémentaire et ladite tranchée formant une structure élémentaire d'amplification ;
   - une opération de collage côté tranchée du substrat élémentaire comprenant au moins ladite tranchée, sur le substrat dit actif,
   - une opération d'élimination du substrat temporaire pour libérer l'actionneur.

Selon une variante de l'invention, le substrat élémentaire est tout ou partie en silicium, le substrat actif est tout ou partie en verre et l'actionneur est tout ou partie en matériau piézoélectrique.

Selon une variante de l'invention, ledit procédé comprend :
- le dépôt d'au moins une couche métallique sur les faces à coller respectivement du substrat élémentaire et du substrat actif ;
- le collage par thermocompression desdites faces comportant lesdites couches métalliques.

Selon une variante de l'invention, ledit procédé comprend une opération d'amincissement dudit substrat élémentaire à partir de ladite face opposée à celle comportant ledit actionneur, cette étape étant réalisée avant l'étape de collage et avant ou après la réalisation de la tranchée.

Selon une variante de l'invention l'opération de collage dudit substrat temporaire est effectuée avec un polymère.

L'invention sera mieux comprise et d'autres avantages apparaîtront à la lecture de la description qui va suivre donnée à titre non limitatif et grâce aux figures annexées parmi lesquelles :
- la figure 1 illustre un exemple de structure mécanique selon l'invention ;
- les figures 2a et 2b illustrent des vues de dessus de structure mécanique respectivement selon l'art connu utilisant une pleine plaque de silicium et une structure de l'invention utilisant une plaque de silicium comportant des tranchées ;
- la figure 3 schématise la déformation sous contrainte d'une structure mécanique de l'invention ;
- la figure 4 illustre l'évolution de l'amplitude de déformation d'un substrat de verre dans différentes configurations liées à différents ratio d'épaisseur substrat de silicium / épaisseur de verre pour un exemple de structure mécanique de l'invention ;
- la figure 5 illustre un exemple d'application utilisant la structure de l'invention dans une application de type switch/interrupteur ou capacité variable
- les figures 6a à 6g illustrent les différentes étapes d'un exemple de procédé de fabrication d'une structure mécanique de la présente invention.

De manière générale, la structure mécanique de la présente invention comporte un substrat dans lequel on cherche à transmettre des vibrations, un actionneur générant lesdites vibrations et une structure élémentaire d'amplification comprenant au moins une tranchée.

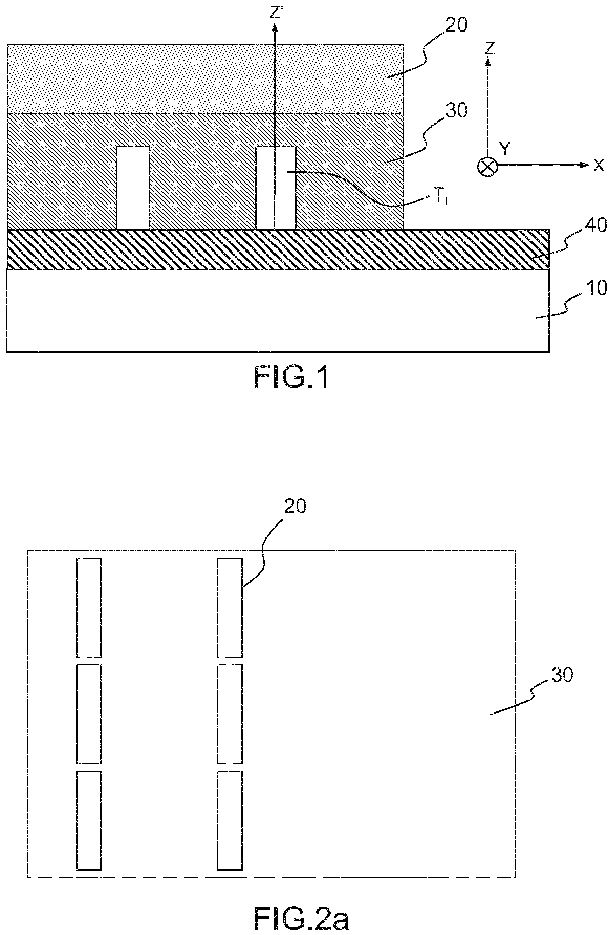

La figure 1 schématise un exemple de structure mécanique de l'invention et met en évidence, un substrat actif 10 dans lequel on cherche à propager un mode de vibration depuis un actionneur 20 via une structure élémentaire d'amplification 30, comprenant au moins une, voire plusieurs tranchées Ti, (deux sur la figure 1) la structure élémentaire 30 étant solidarisée audit substrat par l'intermédiaire par exemple d'une couche de colle 40.

Selon cet exemple, le substrat actif est orienté selon un premier plan défini par deux axes orthogonaux X et Y dans un repère orthonormé (X, Y, Z). Les tranchées sont orientées selon un plan comprenant un axe Z' confondu avec l'axe Z.

Selon d'autres configurations possibles, les tranchées pourraient être orientées selon des plans comprenant un axe Z' faisant un angle non nul avec l'axe Z.

Typiquement, dans différentes applications, on optimise le positionnement de plusieurs actionneurs à la surface d'un substrat dit actif dans lequel on cherche à propager des modes vibrants et préférentiellement un mode centré sur une fréquence optimale.

L'actionneur 20, qui peut être piézoélectrique, thermique ou magnétique, peut se contracter ou se dilater. Par effet bilame, du fait de la présence de la structure élémentaire 30 qui le relie à l'élément à déformer, l'actionneur engendre un couple à l'élément à déformer. Ce couple est amplifié par effet bras de levier de la couche intermédiaire.

Les Demandeurs ont réalisé des simulations permettant de valider le concept de la présente invention à l'aide d'un logiciel de calcul par élément fini Coventor.

Plus précisément, les Demandeurs ont simulé la transmission d'un mode de vibration, que l'on peut dénommer « tôle ondulé », à un substrat par le biais d'un actionneur couche mince, trouvant particulièrement d'intérêt pour des applications de dalle haptique.

Dans ce cadre, les simulations ont été réalisées avec une optimisation de positionnement de plusieurs actionneurs 20 tels qu'illustrés en figure 2a. Deux rangées de trois actionneurs, sont disposées à la surface d'une structure intermédiaire en silicium 30, en vue de transférer un mode de vibration à une dalle en verre. Le mode de vibration, dénommé « tôle ondulé » est aussi influencé par les dimensions des actionneurs (leur largeur et leur longueur).

Les différents cas suivants ont été simulés sur la base d'un actionneur à base de PZT (Titano-Zirconate de Plomb) et sur un substrat type dalle de verre.
- 1) PZT/verre : ceci pourrait correspondre à un cas idéal mais qui est actuellement difficilement envisageable d'un point de vue technologique compte tenu des contraintes de réalisations du PZT couche mince performant sur verre, du fait notamment des fortes températures induites par la mise en forme du PZT ;
- 2) PZT/Or/verre : il a donc été envisagé d'utiliser une couche intermédiaire en or, correspondant d'un point de vue technologique à un report de l'actionneur PZT sur une dalle en verre après suppression du substrat silicium qui a servi à la réalisation du PZT ;
- 3) PZT/Si 10µm/Or/verre : il a également été envisagé un report de l'actionneur PZT sur une dalle en verre après amincissement du substrat silicium pouvant servir à la réalisation du PZT, la couche intermédiaire entre le PZT et le verre étant un bicouche or/silicium ;
- 4) PZT/Si 100µm/Or/Verre : il a encore été envisagé un report de l'actionneur PZT sur une dalle en verre après amincissement moins important que dans le cas précédent, du substrat silicium pouvant servir à la réalisation du PZT, la couche intermédiaire entre le PZT et le verre étant donc un bicouche or/silicium.

Les matériaux cités ci-dessus, sont indicatifs permettant essentiellement de mettre en évidence la différence de transmission du mode au substrat apte à se déformer sous l'action de l'actionneur couche mince lorsqu'il y a présence d'une structure intermédiaire.

La structure intermédiaire peut ainsi être constituée d'une ou de plusieurs couches de matériaux diverses. Elle a un rôle mécanique permettant de coller, reporter l'actionneur sur l'élément vibrant. Elle peut être constituée d'une couche d'or ou d'oxyde ou de silicium. Elle peut aussi être constituée de manière non limitative d'un empilement multi-couches or/silicium ou oxyde/silicium ou encore oxyde/or/silicium.

Les Demandeurs ont ainsi obtenu les résultats de simulation suivants récapitulés dans le Tableau 1 ci-dessous :

| | PZT/verre | PZT/Or/verre | PZT/Si 10µm/Or/verre | PZT/Si 100µm/Or/Verre |
|---|---|---|---|---|
| Fréquence du mode | 20.898 KHz | 20.898 KHz | 21.102 KHz | 21.918 KHz |
| Amplitude de vibration | 45 µm | 28 µm | 18 µm | 16 µm |

Les amplitudes de vibration ont été simulées avec un amortissement arbitraire dans l'air sous - 30V.

Ces résultats sont relatifs et non pas absolus pour obtenir des amplitudes absolues, il conviendrait d'extraire au préalable un coefficient d'amortissement à partir de la mesure. Plus précisément, on effectue une simulation en introduisant un coefficient d'amortissement que l'on ajuste afin que la simulation donne un résultat en bon accord avec la mesure effectuée sur un dispositif réalisé.

Il apparait que la présence d'une couche d'or fait grandement chuter l'amplitude de vibration de la dalle par rapport au cas idéal PZT/verre. Les Demandeurs ont par ailleurs observé que la présence d'une couche d'or induisait l'apparition de modes parasites.

En conservant 10µm ou 100µm de silicium, l'amplitude de vibration est d'autant plus amortie (car la présence du silicium induit une augmentation de la rigidité globale du système), et des modes parasites apparaissent d'autant plus, jusqu'à rendre très incertaine l'obtention du mode au final.

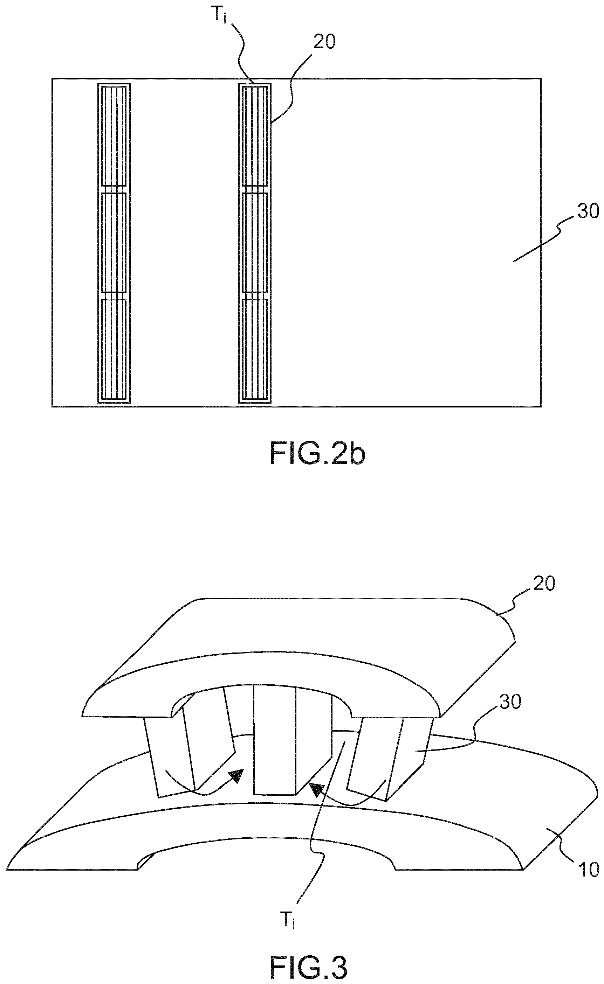

A partir de ces simulations, les Demandeurs ont étudié l'effet de l'introduction de tranchées dans une structure intermédiaire en silicium, permettant de provoquer l'effet bras de levier, dans une configuration illustrée en figure 2b qui schématise des tranchées Ti réalisées dans la structure amplificatrice 30.

L'effet bras de levier est schématisé en figure 3. L'actionneur 20 qui peut être piézoélectrique, thermique ou magnétique, peut se contracter ou se dilater. Par effet bilame, du fait de la présence de la structure d'amplification intermédiaire 30 qui le relie à l'élément à déformer 10, l'actionneur engendre un couple, transmis à l'élément à déformer. Ce couple est amplifié par effet bras de levier de la couche intermédiaire 30.

Ainsi, en utilisant la structure élémentaire de l'invention, avec des tranchées, il devient possible de favoriser la déformation à transmettre à l'élément à déformer ou le mode voulu et même augmenter son amplitude par rapport au cas du mode obtenu avec la présence de la même couche de silicium sans tranchées comme le montre le Tableau 2 ci-après :

**Tableau 2**

| | PZT/Verre | PZT/Or/ver re | PZT/Si 10µm/Or/verre | PZT/Si 100µm/Or/Verre | PZT/Si tranché 10 µm/or/Verre |
|---|---|---|---|---|---|
| Fréquence du mode | 20.898 KHz | 20.898 KHz | 21.102 KHz | 21.918 KHz | 20.898 KHz |
| Amplitude de vibration | 45 µm | 28 µm | 18 µm | 16 µm | 25 µm |

Ainsi par l'introduction de tranchées dans la structure en silicium, on tire bénéfice de la présence du silicium sous l'actionneur plutôt que d'en pâtir. Les tranchées de silicium jouent le rôle de bras de levier en amplifiant l'amplitude du mode (25µm avec les tranchées dans le silicium contre 18µm pour la même épaisseur de silicium sans tranchées). Les tranchées jouent également le rôle de « filtre » en favorisant le mode voulu. En effet, les Demandeurs ont observé que l'on conservait le mode souhaité en éliminant des modes parasites.

Les couches mentionnées ci-dessus, constitutives de la structure mécanique de l'invention, ne le sont qu'à titre d'exemple et la présente invention peut être généralisée à d'autres matériaux piézoélectriques que le PZT et à d'autres types d'actionneurs que des actionneurs piézoélectriques.

Ainsi, le matériau piézoélectrique peut être du PZT, de l'AIN, du LNO, BST ou autre.

L'actionneur peut être thermique (même schéma de principe que le piézoélectrique, l'actionneur est dans ce cas une résistance thermique, typiquement un métal comme l'aluminium ou l'or...) ou magnétique (dans ce cas l'actionneur est un matériau magnétique).

Le substrat dit actif peut être en verre, polymère ou autre.

La structure amplificatrice peut comprendre des couches intermédiaires pouvant être en oxyde, silicium, polysilicium, or, ...

Les tranchées peuvent être prévues uniquement dans le silicium car cette solution est facilement réalisable technologiquement. Néanmoins des tranchées débouchantes allant du substrat dit actif à l'actionneur sont envisageables.

Les épaisseurs des matériaux de la structure amplificatrice peuvent typiquement être comprises entre une centaine de nanomètres et quelques microns, voir quelques dizaines de microns.

Typiquement, la structure d'amplification peut être en silicium, la couche de colle étant métallique par exemple en or.

Les Demandeurs ont également mis en évidence qu'il pouvait exister une épaisseur optimale de la structure amplificatrice.

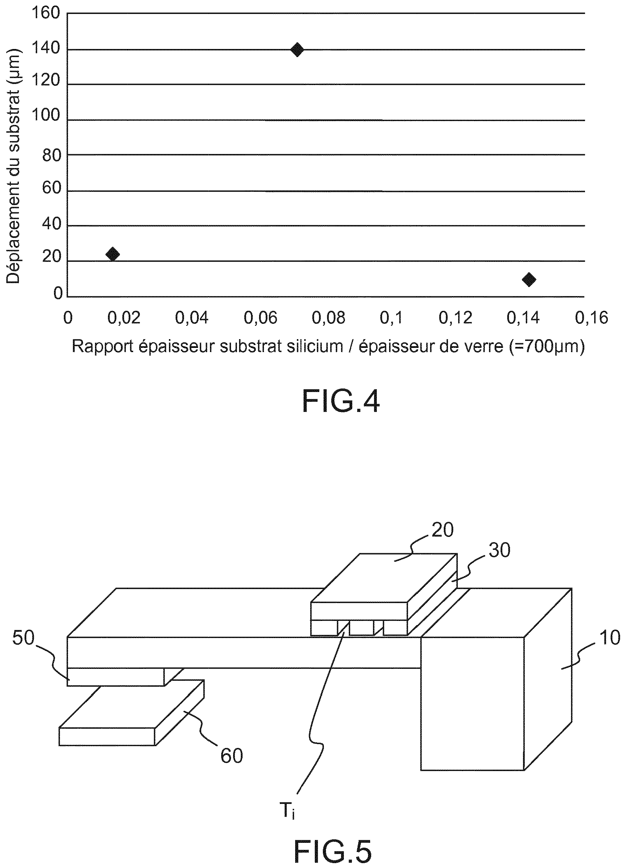

Pour cela il a réalisé différentes simulations FEM sous Coventor pour trouver l'épaisseur de substrat de silicium optimum. Le substrat silicium servant de support à la réalisation des actionneurs couche mince en PZT doit être aminci. Comme le montre la figure 4, un optimum existe, et une épaisseur restante de silicium de l'ordre de 40 à 60µm semble permettre la plus grande déformation du substrat.

Cette valeur est liée à l'épaisseur et à la nature du substrat de verre qui ont été utilisées en simulation, à savoir 700µm, mais la méthodologie peut être transcrite pour d'autre dimensions et d'autres matériaux.

Les Demandeurs ont ainsi établi une courbe relative au déplacement du substrat, illustré par l'amplitude du mode de vibration d'intérêt en fonction du rapport des épaisseurs : silicium aminci /substrat actif de verre. L'optimum se trouve ainsi être autour de 0.08.

De même, les Demandeurs ont mis en évidence que la répartition des tranchées ainsi que leur dimensionnement dans la structure amplificatrice permettaient d'accroître le phénomène d'amplification.

Des tranchées trop fines et/ou trop proches les unes des autres, ne permettront pas de baisser significativement la rigidité induite par le silicium, alors que des tranchées très larges et très éloignées qui réduisent grandement la rigidité, amènent des problèmes d'un point de vue technologique comme un mauvais collage. Il convient donc de trouver le meilleur compromis entre ces deux effets.

Les Demandeurs ont mis en évidence les bonnes performances obtenues avec des tranchées de 5 à 1000 µm et espacées d'une distance pouvant typiquement être comprise entre 5 à 1000µm et plus particulièrement avec des tranchées présentant une largeur de 300µm et espacées de 400µm.

Il est à noter que la couche de silicium peut être entièrement tranchée (tranchées traversant l'épaisseur du silicium) ou partiellement tranchée comme l'indique le Tableau 3 suivant.

**Tableau 3**

| Cas | Tranchées débouchantes | Tranchées partielles (10µm de Si restant) | Tranchées partielles (20µm de Si restant) |
|---|---|---|---|
| Amplitude de déformation du substrat (simulation par éléments finis avec -30V appliquée sur le matériau piézoélectrique | 140 µm | 50 µm | 15 µm |
| Contrainte principale (stress principal, comparaison relative) | 630 | 380 | 250 |

Il apparaît que si l'on perd en efficacité d'amplification du mouvement mécanique par l'utilisation de tranchées partielles (l'amplitude de déformation du substrat passe de 140 à 50 puis 15µm), on peut réduire grandement la contrainte engendrée dans l'actionneur par la déformation du substrat (contrainte principale passant de 630 à 380 puis 250). Cette baisse de contrainte peut augmenter la fiabilité du système.

On privilégie ainsi des tranchées débouchantes induisant une plus grande amplification.

### Premier exemple d'application utilisant la structure de l'invention : la dalle haptique.

De manière générale, une dalle haptique fonctionne par un effet de lame d'air, créé à la surface de la dalle par la vibration de cette dernière. Cette vibration est engendrée par des actionneurs piézoélectriques collés ou déposés et gravés sur la plaque.

Pour un bon effet haptique, il est nécessaire d'obtenir une amplitude de vibration typiquement d'environ 1µm dans le mode « tôle ondulée ».

Du fait de son fort coefficient piézoélectrique, le PZT correspond à un excellent candidat pour réaliser actionneur afin d'obtenir des dalles haptiques intégrées, présentant de bonnes performances, utilisant de faibles tensions d'actionnement, en comparaison notamment à d'autres matériaux piézoélectriques tels que LNO pou AIN.

Les dalles haptiques ayant notamment pour application les smart phones ou tablette PC, il est nécessaire d'utiliser une dalle vibrante transparente, et ne pouvant donc être en silicium.

Un dépôt direct de matériau PZT sur verre n'étant pas compatible avec les fortes températures de cristallisation requise pour le PZT déposé par la méthode sol-gel, il est également nécessaire d'utiliser une structure intermédiaire, comme explicité précédemment.

Dans ce contexte, la présente invention revêt un intérêt majeur permettant via l'utilisation d'une structure nécessaire intermédiaire, de rendre celle-ci amplificatrice de modes de vibration transmis.

Pour une telle réalisation, une variante de la présente invention consiste à transférer les actionneurs PZT réalisés sur silicium sur une plaquette en verre.

Pour cela, on peut découper des barrettes d'actionneurs PZT réalisées sur silicium servant de substrat élémentaire et les fixer sur substrat temporaire dénommé ci-après poignée temporaire permettant d'amincir partiellement ou de supprimer le substrat en silicium, puis de transférer et fixer les barrettes d'actionneur sur les dalles en verre par une thermocompression métal-métal par exemple : or-or.

### Second exemple d'application utilisant la structure de l'invention : Switch ou capacité variable.

La figure 5 illustre ainsi un exemple dans lequel on amplifie la déformation d'un actionneur 20, via une structure d'amplification 30 comprenant des tranchées Ti, ladite déformation pouvant être transmise et amplifiée à une poutre par exemple 10, pour réaliser un switch ou une capacité variable, équipée d'un contact propre ou d'une électrode mobile 50, en regard d'un contact ou d'une électrode 60 fixe. Ce contact ou électrode fixe est sur un support mécanique sur lequel a été monté ou réalisé les switch ou la capacité variable. En particulier, ce support mécanique peut être un substrat de silicium. Dans ce cas il s'agit de déformer une poutre bi-encastrée ou simplement encastrée sous l'effet d'une tension appliquée à l'actionneur. La déformation de la poutre est amplifiée pour aller plus vite provoquer le contact entre l'élément mobile et le contact fixe, ou pour augmenter la différence de capacité entre les deux électrodes face à face.

On peut également mentionner d'autres exemples tels que :
- ceux utilisant une membrane et notamment :
   ∘ un haut-parleur utilisant un composant MEMS comprenant une membrane, activé par un actionneur, l'actionnement de la membrane permettant de réaliser un pulse acoustique ;
   ∘ une micro pompe utilisant le déplacement d'une membrane par exemple pour dispenser de l'insuline ou tout autre médicament ;
- un dispositif pour l'imagerie photoacoustique. Dans ce cas le pulse acoustique, créé par le déplacement de l'air engendré par l'actionnement de la membrane, est envoyé sur une cellule ou un élément à « sonder ». La réflexion de l'onde acoustique peut être enregistrée et analysée pour faire de l'imagerie ;
- un résonateur électromécanique servant comme base de temps. Dans ce cas l'actionneur doit provoquer un mode de vibration à une fréquence donnée. Cette fréquence sert de référence de temps pour une électronique telle que celle gérant les téléphones mobiles. Plus la vibration sera grande, plus elle sera distincte du bruit électronique environnant, et plus elle sera efficacement utilisée par l'électronique. Dans le cas de l'invention, il est possible d'amplifier la vibration, et donc d'augmenter le rapport signal sur bruit afin d'augmenter la qualité du résonateur électromécanique.

### Exemple de procédé de fabrication d'une structure mécanique de l'invention comprenant au moins plusieurs actionneurs piézoélectriques et pouvant avantageusement être utilisée dans une dalle haptique.

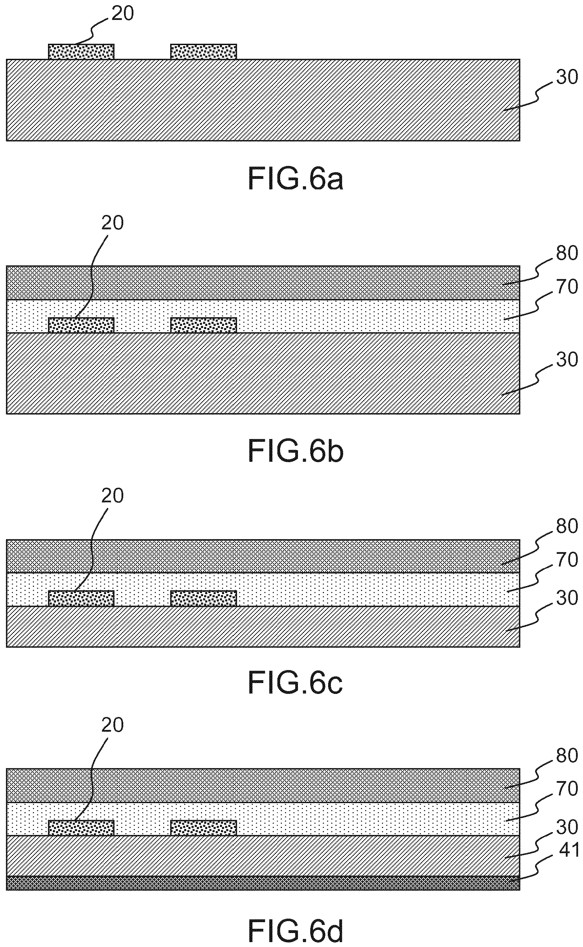

Les principales étapes du procédé sont illustrées grâce aux figures 6a à 6g.

Selon une première étape illustrée en figure 6a, on réalise à la surface d'un substrat élémentaire en silicium 30 destiné à servir de structure élémentaire d'amplification, des actionneurs piézoélectriques 20 comprenant au moins une couche de matériau piézoélectrique compris entre des électrodes.

Selon une seconde étape illustrée en figure 6b, on réalise le collage d'une poignée temporaire 80 par l'intermédiaire d'une colle 70. La poignée temporaire peut être un substrat pouvant être en tout type de matériau, la couche de colle 70 pouvant être en polymère, pouvant être rendu fluide par chauffage.

Selon une troisième étape illustrée en figure 6c, on procède à une opération d'amincissement du substrat 30 (par exemple par polissage mécano-chimique).

Selon une quatrième étape illustrée en figure 6d, on réalise un dépôt métallique 41 par exemple en or, en face arrière du substrat 30, ledit dépôt métallique étant destiné au collage d'un substrat actif (type dalle de verre par exemple).

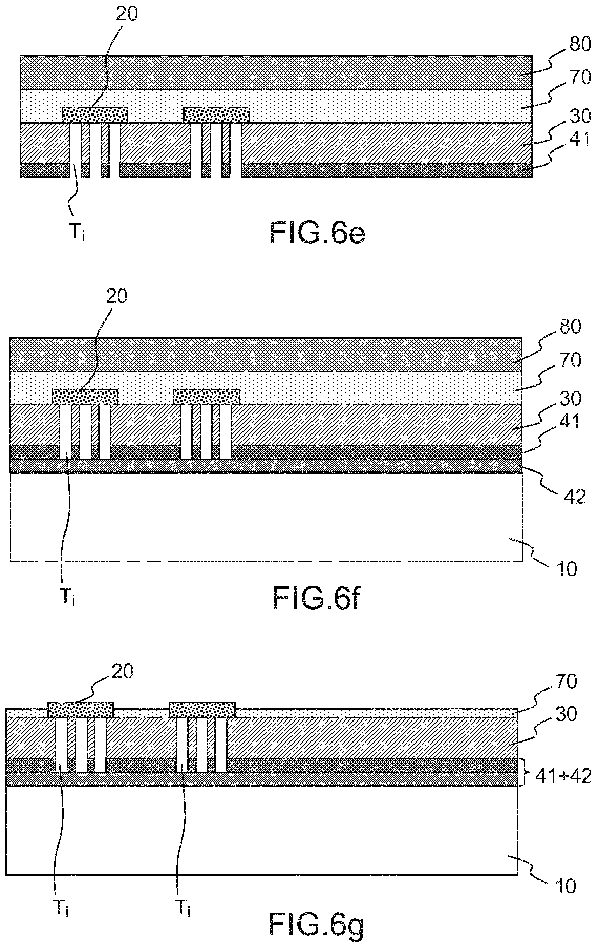

Selon une cinquième étape illustrée en figure 6e, on réalise par gravure des tranchées Ti, dans ledit substrat 30 et dans la couche de colle 41, depuis la face arrière Les zones à graver sont préalablement définie par une étape de photolithographie.

Selon une sixième étape illustrée en figure 6f, on vient coller un substrat actif 10 dans lequel on cherche à propager des vibrations préalablement recouvert d'une couche métallique 42. Le collage peut être réalisé par thermocompression après mise en contact des deux couches 41 et 42.

Selon une septième étape illustrée en figure 6g, on procède au décollage de ladite poignée temporaire 80 et l'on procède également à une étape de dégagement de la couche de collage 70 (partiellement comme représenté ou totalement) au niveau desdits actionneurs 20. La couche de collage peut-être partiellement enlevée ou totalement enlevée comme avantageusement pour un collage polymère.

Typiquement lorsque l'on a utilisé un polymère de collage, cette dernière opération peut être réalisée par élévation de température (par toute source de chaleur) rendant ledit polymère malléable et permettant donc de désolidariser le substrat temporaire appelé poignée, de l'ensemble de la structure mécanique de l'invention qui a été réalisée.

## Revendications

1. Structure mécanique comprenant un empilement comportant un substrat actif (10) et au moins un actionneur (20) adapté pour générer des vibrations au niveau dudit substrat actif, ledit empilement comprenant une structure élémentaire d'amplification desdites vibrations (30) :
- disposée entre ledit actionneur (20) et ledit substrat actif (10), la structure étant adaptée pour transmettre et amplifier lesdites vibrations et ;
- comprenant au moins une tranchée (Ti), située entre ledit actionneur (20) et ledit substrat actif (10) **caractérisée en ce que** ladite tranchée (Ti) est débouchante au moins sur ledit substrat actif (10).

2. Structure mécanique selon la revendication 1, **caractérisée en ce que** ladite structure élémentaire comprend un empilement de couches dont au moins une couche comprend ladite tranchée.

3. Structure mécanique selon l'une des revendications 1 ou 2, **caractérisée en ce que** le substrat présentant une surface orientée dans un premier plan défini par deux axes X et Y orthogonaux, ladite structure élémentaire comprend des tranchées (Ti) réparties périodiquement selon ledit premier plan entre ledit actionneur et ledit substrat.

4. Structure mécanique selon l'une des revendications 1 à 3, **caractérisée en ce qu'**elle comprend plusieurs actionneurs couplés à au moins une structure élémentaire d'amplification, sur ledit substrat actif.

5. Structure mécanique selon l'une des revendications 1 à 4, **caractérisée en ce que** l'actionneur est un actionneur piézoélectrique.

6. Structure mécanique selon la revendication 5, **caractérisée en ce que** l'actionneur piézoélectrique comprend au moins une couche de matériau piézoélectrique pouvant être en PZT, ou AIN, ou en LNO, ou en BST.

7. Structure mécanique selon l'une des revendications 1 à 4, **caractérisée en ce que** l'actionneur comprend une résistance thermique pouvant comprendre au moins une couche de métal, adaptée pour assurer un actionnement thermique.

8. Structure mécanique selon l'une des revendications 1 à 4, **caractérisé en ce que** l'actionneur comprend au moins une couche en matériau magnétique, permettant d'assurer un actionnement magnétique.

9. Structure mécanique selon l'une des revendications 1 à 8, **caractérisée en ce que** le substrat actif est tout ou partie en verre, ou en polymère, ou en silicium.

10. Structure mécanique selon l'une des revendications 1 à 9, **caractérisée en ce que** la structure élémentaire comprend au moins une partie en silicium.

11. Structure mécanique selon les revendications 5 et 10, **caractérisée en ce qu'**elle comprend :
- un actionneur pouvant comprendre une couche piézoélectrique ;
- une structure élémentaire en silicium ;
- un substrat actif en verre.

12. Structure mécanique selon la revendication 11, **caractérisée en ce que** la ou les tranchées présentent une largeur comprise entre environ de 5 µm et 1000 µm et dans le cas de plusieurs tranchées, lesdites tranchées étant espacées d'une distance pouvant typiquement être comprise entre 5 µm à 1000 µm.

13. Procédé de fabrication d'une structure mécanique comprenant un empilement comportant un substrat actif (10) et au moins un actionneur (20) adapté pour générer des vibrations au niveau dudit substrat actif, ledit empilement comprenant une structure élémentaire d'amplification desdites vibrations (30) :
- disposée entre ledit actionneur (20) et ledit substrat actif (10), la structure étant adaptée pour transmettre et amplifier lesdites vibrations et ;
- comprenant au moins une tranchée (Ti), située entre ledit actionneur (20) et ledit substrat actif (10), le procédé comprenant les étapes suivantes :
- la réalisation d'au moins un actionneur (20) à la surface d'un substrat élémentaire (30) ;
- une opération de collage dudit substrat élémentaire côté actionneur, sur un substrat temporaire (80);
- la réalisation d'au moins une tranchée (Ti) dans ledit substrat élémentaire, en face opposée à celle comportant ledit actionneur, le substrat élémentaire et ladite tranchée formant une structure élémentaire d'amplification ;
- une opération de collage côté tranchée du substrat élémentaire comprenant au moins ladite tranchée, sur le substrat dit actif,
- une opération d'élimination du substrat temporaire pour libérer l'actionneur.

14. Procédé de fabrication selon la revendication 13, **caractérisé en ce que** le substrat élémentaire est tout ou partie en silicium, le substrat actif est tout ou partie en verre et l'actionneur est tout ou partie en matériau piézoélectrique.

15. Procédé de fabrication selon la revendication 13 ou 14, **caractérisé en ce que** l'opération de collage comprend :
- le dépôt d'au moins une couche métallique sur les faces à coller respectivement du substrat élémentaire et du substrat actif ;
- le collage par thermocompression desdites faces comportant lesdites couches métalliques.

16. Procédé de fabrication selon l'une des revendications 13 à 15, **caractérisé en ce qu'**il comprend une opération d'amincissement dudit substrat élémentaire à partir de ladite face opposée à celle comportant ledit actionneur, cette étape étant réalisée avant l'étape de collage et avant ou après la réalisation de la tranchée.

17. Procédé de fabrication selon l'une des revendications 13 à 16, **caractérisé en ce que** l'opération de collage dudit substrat temporaire est effectué avec un polymère.

## Patentansprüche

1. Mechanische Struktur, die einen Stapel umfasst, der ein aktives Substrat (10) und mindestens einen Aktuator (20) aufweist, der zum Erzeugen von Schwingungen an dem aktiven Substrat eingerichtet ist, wobei der Stapel eine elementare Struktur zur Verstärkung der Schwingungen (30) umfasst:
- die zwischen dem Aktuator (20) und dem aktiven Substrat (10) angeordnet ist, wobei die Struktur zum Übertragen und Verstärken der Schwingungen eingerichtet ist, und
- die mindestens einen Graben (Ti) umfasst, der sich zwischen dem Aktuator (20) und dem aktiven Substrat (10) befindet,
**dadurch gekennzeichnet, dass** der Graben (Ti) mindestens auf dem aktiven Substrat (10) mündet.

2. Mechanische Struktur nach Anspruch 1, **dadurch gekennzeichnet, dass** die elementare Struktur einen Schichtstapel umfasst, von dem mindestens eine Schicht den Graben umfasst.

3. Mechanische Struktur nach einem der Ansprüche 1 oder 2, **dadurch gekennzeichnet, dass** das Substrat eine Oberfläche aufweist, die in einer durch zwei orthogonale X- und Y-Achsen definierte ersten Ebene orientiert ist, wobei die elementare Struktur Gräben (Ti) umfasst, die periodisch entlang der ersten Ebene zwischen dem Aktuator und dem Substrat verteilt sind.

4. Mechanische Struktur nach einem der Ansprüche 1 bis 3, **dadurch gekennzeichnet, dass** sie mehrere Aktuatoren umfasst, die mit mindestens einer elementaren Verstärkungsstruktur auf dem aktiven Substrat gekoppelt sind.

5. Mechanische Struktur nach einem der Ansprüche 1 bis 4, **dadurch gekennzeichnet, dass** der Aktuator ein piezoelektrischer Aktuator ist.

6. Mechanische Struktur nach Anspruch 5, **dadurch gekennzeichnet, dass** der piezoelektrische Aktuator mindestens eine Schicht aus piezoelektrischem Material umfasst, das aus PZT, AIN, LNO oder BST bestehen kann.

7. Mechanische Struktur nach einem der Ansprüche 1 bis 4, **dadurch gekennzeichnet, dass** der Aktuator einen thermischen Widerstand umfasst, der mindestens eine Metallschicht umfassen kann, die zum Gewährleisten einer thermischen Betätigung eingerichtet ist.

8. Mechanische Struktur nach einem der Ansprüche 1 bis 4, **dadurch gekennzeichnet, dass** der Aktuator mindestens eine Schicht aus magnetischem Material umfasst, die es ermöglicht, eine magnetische Betätigung zu gewährleisten.

9. Mechanische Struktur nach einem der Ansprüche 1 bis 8, **dadurch gekennzeichnet, dass** das aktive Substrat ganz oder teilweise aus Glas oder Polymer oder Silizium besteht.

10. Mechanische Struktur nach einem der Ansprüche 1 bis 9, **dadurch gekennzeichnet, dass** die elementare Struktur mindestens einen Teil aus Silizium umfasst.

11. Mechanische Struktur nach den Ansprüchen 5 und 10, **dadurch gekennzeichnet, dass** sie Folgendes umfasst:
- einen Aktuator, der eine piezoelektrische Schicht umfassen kann;
- eine elementare Struktur aus Silizium;
- ein aktives Glassubstrat.

12. Mechanische Struktur nach Anspruch 11, **dadurch gekennzeichnet, dass** der Graben oder die Gräben eine Breite zwischen etwa 5 µm und 1000 µm aufweisen und im Falle von mehreren Gräben die Gräben um eine Distanz beabstandet sind, die typischerweise zwischen 5 µm und 1000 µm liegen kann.

13. Verfahren zur Herstellung einer mechanischen Struktur, die einen Stapel umfasst, der ein aktives Substrat (10) und mindestens einen Aktuator (20) aufweist, der zum Erzeugen von Schwingungen an dem aktiven Substrat eingerichtet ist, wobei der Stapel eine elementare Struktur zur Verstärkung der Schwingungen (30) umfasst:
- die zwischen dem Aktuator (20) und dem aktiven Substrat (10) angeordnet ist, wobei die Struktur zum Übertragen und Verstärken der Schwingungen eingerichtet ist, und
- die mindestens einen Graben (Ti) umfasst, der sich zwischen dem Aktuator (20) und dem aktiven Substrat (10) befindet,
wobei das Verfahren die folgenden Schritte umfasst:
- Herstellen mindestens eines Aktuators (20) auf der Oberfläche eines elementaren Substrats (30);
- einen Vorgang des Klebens des elementaren Substrats auf der Seite des Aktuators auf ein temporäres Substrat (80);
- Herstellen mindestens eines Grabens (Ti) in dem elementaren Substrat an der Fläche, die der den Aktuator aufweisenden Fläche gegenüberliegt, wobei das elementare Substrat und der Graben eine elementare Verstärkungsstruktur bilden;
- einen Vorgang des Klebens des mindestens den Graben umfassenden elementaren Substrats auf der Seite des Grabens auf das sogenannt aktive Substrat,
- einen Vorgang des Entfernens des temporären Substrats, um den Aktuator freizugeben.

14. Herstellungsverfahren nach Anspruch 13, **dadurch gekennzeichnet, dass** das elementare Substrat ganz oder teilweise aus Silizium besteht, das aktive Substrat ganz oder teilweise aus Glas besteht und der Aktuator ganz oder teilweise aus piezoelektrischem Material besteht.

15. Herstellungsverfahren nach Anspruch 13 oder 14, **dadurch gekennzeichnet, dass** der Klebevorgang Folgendes umfasst:
- Aufbringen mindestens einer Metallschicht auf die zu klebenden Flächen des elementaren Substrats bzw. des aktiven Substrats;
- Kleben der die Metallschichten aufweisenden Flächen durch Thermokompression.

16. Herstellungsverfahren nach einem der Ansprüche 13 bis 15, **dadurch gekennzeichnet, dass** es einen Vorgang des Verdünnens des elementaren Substrats von der Fläche, die der den Aktuator aufweisenden Fläche gegenüberliegt, umfasst, wobei dieser Schritt vor dem Schritt des Klebens und vor oder nach der Herstellung des Grabens durchgeführt wird.

17. Herstellungsverfahren nach einem der Ansprüche 13 bis 16, **dadurch gekennzeichnet, dass** der Klebevorgang des temporären Substrats mit einem Polymer durchgeführt wird.

## Claims

1. A mechanical structure comprising a stack containing an active substrate (10) and at least one actuator (20) adapted to generate vibrations at said active substrate, said stack comprising an elementary structure for amplifying said vibrations (30):
- arranged between said actuator (20) and said active substrate (10), the structure being adapted to transmit and amplify said vibrations and;
- comprising at least one trench (Ti) located between said actuator (20) and said active substrate (10);
**characterised in that** said trench (Ti) opens at least on said active substrate (10).

2. The mechanical structure according to claim 1, **characterised in that** said elementary structure comprises a stack of layers, at least one layer of which comprises said trench.

3. The mechanical structure according to one of claim 1 or 2, **characterised in that** the substrate has a surface which is oriented in a first plane defined by two orthogonal axes X and Y, said elementary structure comprises trenches (Ti) that are distributed periodically along said first plane between said actuator and said substrate.

4. The mechanical structure according to one of claims 1 to 3, **characterised in that** it comprises multiple actuators coupled with at least one elementary amplification structure, on said active substrate.

5. The mechanical structure according to one of claims 1 to 4, **characterised in that** the actuator is a piezoelectric actuator.

6. The mechanical structure according to claim 5, **characterised in that** the piezoelectric actuator comprises at least one layer of piezoelectric material that may be made of PZT, AIN, LNO or BST.

7. The mechanical structure according to one of claims 1 to 4, **characterised in that** the actuator comprises a thermal resistor that may comprise at least one metal layer, adapted to carry out a thermal actuation.

8. The mechanical structure according to one of claims 1 to 4, **characterised in that** the actuator comprises at least one layer made of magnetic material, allowing a magnetic actuation to be carried out.

9. The mechanical structure according to one of claims 1 to 8, **characterised in that** the active substrate is entirely or partly made of glass, polymer, or silicon.

10. The mechanical structure according to one of claims 1 to 9, **characterised in that** the elementary structure comprises at least one portion made of silicon.

11. The mechanical structure according to claims 5 and 10, **characterised in that** it comprises:
- an actuator that may comprise a piezoelectric layer;
- an elementary structure made of silicon;
- an active substrate made of glass.

12. The mechanical structure according to claim 11, **characterised in that** the width of the trench or trenches is between approximately 5 µm and 1000 µm and, in the case of multiple trenches, said trenches are spaced apart by a distance that may typically be between 5 µm and 1000 µm.

13. A method for manufacturing a mechanical structure comprising a stack containing an active substrate (10) and at least one actuator (20) adapted to generate vibrations at said active substrate, said stack comprising an elementary structure for amplifying said vibrations (30):
- arranged between said actuator (20) and said active substrate (10), the structure being adapted to transmit and amplify said vibrations and;
- comprising at least one trench (Ti) located between said actuator (20) and said active substrate (10),
the method comprising the following steps:
- producing at least one actuator (20) on the surface of an elementary substrate (30);
- an operation of bonding said elementary substrate, on the actuator side, to a temporary substrate (80);
- producing at least one trench (Ti) in said elementary substrate, at the face opposite that containing said actuator, the elementary substrate and said trench forming an elementary amplification structure;
- an operation of bonding, on the trench side, said elementary substrate comprising at least said trench to the so-called active substrate;
- an operation of removing the temporary substrate to free the actuator.

14. The manufacturing method according to claim 13, **characterised in that** the elementary substrate is entirely or partly made of silicon, the active substrate is entirely or partly made of glass and the actuator is entirely or partly made of piezoelectric material.

15. The manufacturing method according to claim 13 or 14, **characterised in that** the bonding operation comprises:
- the deposition of at least one metal layer on the faces to be bonded of the elementary substrate and of the active substrate, respectively;
- bonding, by means of thermocompression, said faces containing said metal layers.

16. The manufacturing method according to one of claims 13 to 15, **characterised in that** it comprises an operation of thinning said elementary substrate from said face opposite that containing said actuator, this step being carried out before the bonding step and before or after producing the trench.

17. The manufacturing method according to one of claims 13 to 16, **characterised in that** the operation of bonding said temporary substrate is carried out using a polymer.
